(19) Europäisches Patentamt

European Patent Office

Office européen des brevets

(11) **EP 1 612 950 A1**

(12) **EUROPEAN PATENT APPLICATION**

(43) Date of publication:
**04.01.2006 Bulletin 2006/01**

(51) Int Cl.:
*H03M 13/15* (2006.01)       *G06F 11/10* (2006.01)

(21) Application number: **04425486.0**

(22) Date of filing: **30.06.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **STMicroelectronics S.r.l.**
**20041 Agrate Brianza (Milano) (IT)**

(72) Inventors:
• **Marelli, Alessia**
**24044 Dalmine (Bergamo) (IT)**

• **Ravasio, Roberto**
**24036 Ponte San Pietro (Bergamo) (IT)**
• **Micheloni, Rino**
**22078 Turate (Como) (IT)**

(74) Representative: **Ferrari, Barbara**
**Botti & Ferrari S.r.l.,**
**Via Locatelli, 5**
**20124 Milano (IT)**

(54) **Method and system for correcting errors during read and write to non volatile memories**

(57)     The invention relates to a method and system for correcting errors in multilevel memories, both of the NAND and of the NOR type. The method provides the use of a BCH correction code made parallel by means of a coding and decoding architecture allowing the latency limits of prior art sequential solutions to be overcome. Two possible solutions are shown.

The parallelism being used for blocks C, 1 and 3 can be chosen in order to optimise the system performances in terms of latency and device area.

FIG. 20

EP 1 612 950 A1

**Description**

Field of application

The present invention relates to a method and system for correcting low latency errors in read and write non volatile memories, particularly electronic Flash memories.

The invention particularly relates to read and write memories having a NAND structure and the following description is made with reference to this specific field of application for convenience of illustration only, since the invention can be also applied to memories with NOR structure, provided that they are equipped with an error correction system.

Even more particularly, the invention relates to a method and system for correcting errors in electronic read and write non volatile memory devices, particularly Flash memories, of the type providing at least the use of a BCH binary error correction code for the information data to be stored.

Prior art

As it is well known in this specific technical field, two-level and multilevel NAND memories have such a Bit Error Rate (BER) as to require an Error Correction system (ECC) in order to allow them to be used as reliably as possible.

Among the innumerable present ECC correction methods a particular interest is assumed by the so-called cyclical correction codes; particularly binary BCH and Reed-Solomon codes.

The main features concerning these two codes are quoted hereafter by way of comparison.

The code will be examined first:

1) Binary BCH.

This code operates on a block of binary symbols. If N (4096 + 128) is the block size, the number of parity bits is P (assuming to correct 4 bits, P is equal to 52bits).

As it will be seen hereafter, the code operates on a considerably lower number of bits with respect to the Reed-Solomon code.

The canonical coding and decoding structures process the data block by means of sequential operations on the bits to be coded or decoded.

The latency to code and decode data blocks is higher than the Reed-Solomon code latency since it operates on symbols.

The arithmetic operators (sum, multiplication, inversion) in GF(2), and thus those necessary for this kind of code, are extremely simple (XOR, AND, NOT).

The code corrects K bits.

The other code will now be seen:

2) Reed Solomon

It operates on a block of symbols composed by a plurality of bits.

If N ((4096 + 128) /9) is the symbol block size, the number of parity symbols is P (assuming to correct 4 errors, P is equal to 8 symbols formed by 9-bit, i.e. 72 bits).

The canonical coding and decoding structures process the data block by means of sequential operations on the symbols to be coded or decoded.

In this case, the latency to code and decode data blocks is lower than the BCH binary code latency since it operates on symbols rather than bits (1/9).

Another difference is due to the fact that the arithmetic operators (sum, multiplication, inversion) in $GF(2^m)$ are in this case complex operators with respect to the BCH code.

The code corrects K symbols. This is very useful in communication systems such as: Hard disks, Tape Recorders, CD-ROMs etc. wherein sequential errors are very probable. This latter feature cannot be fully used in NAND memories.

For a better understanding of all the aspects of the present invention, the structure of the error correction systems using a BCH coding and decoding will be analysed hereafter, the structure of Reed Solomon correction systems will be analysed afterwards.

The BCH structure

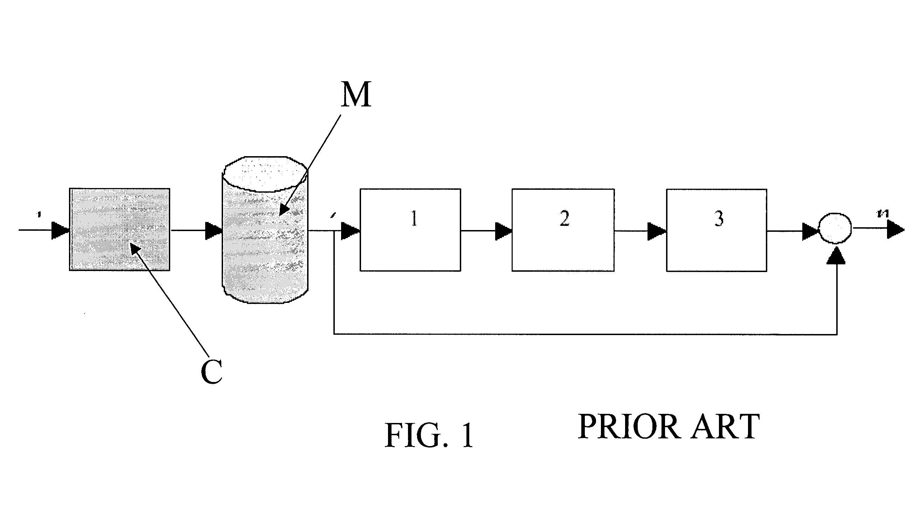

The typical structure of a BCH code is shown in the attached figure 1 wherein the block indicated with C represents the coding step while the other blocks 1, 2 and 3 are active during the decoding and they refer to the syndrome calculation, to the error detection polynomial calculation (for example by means of the known Berlekamp-Massey algorithm) and to the error detection, respectively. The block M indicates a storage and/or transfer medium of the coded data.
Blocks C, 1 and 3 can be realised by means of known structures, (for example according to what has been described by: Shu Lin, Daniel Costello - "Error Control Coding: Fundamentals and Applications") operating in a serial way and thus having a latency being proportional to the length of the message to be stored.
In particular:

BLOCK C: the block latency is equal to the message to be stored (4096 bits);

BLOCK 1: the block latency is equal to the coded message (for a four-error-corrector code 4096+52);

BLOCK 3: the block latency is equal to the coded message (for a four-error-corrector code 4096+52).

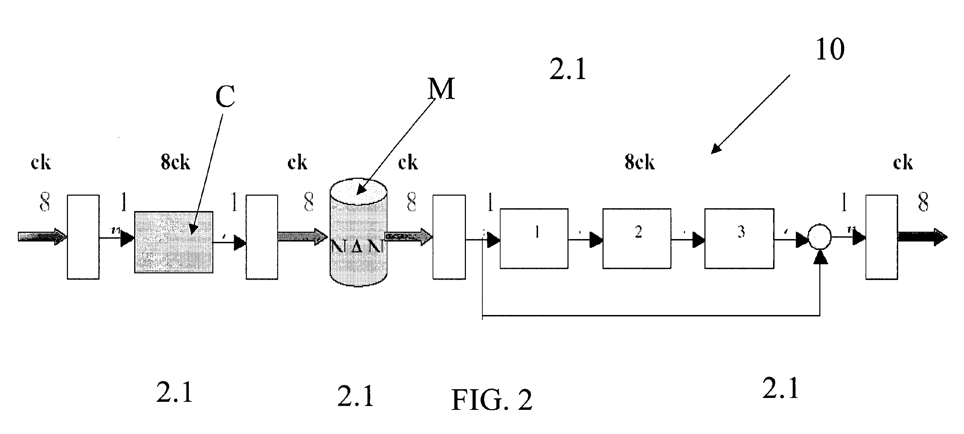

Figure 2 shows the flow that the data being written and read by a memory must follow in order to be coded and decoded by means of a BCH coding system. Bits traditionally arrive to the coder of the block C in groups of eight, while the traditional BCH coder processes one bit at a time. Similarly, bits are traditionally stored and read in groups of eight, while the traditional BCH decoder (1 and 3) processes them in a serial way.
Blocks (2.1) grouping or decomposing the bits to satisfy said requirements are thus required in the architecture.
Consequently, in order not to slow the data flow down, it is required that the coder and the decoder operate with a clock time being eight times higher than the clock of the data storage and reading step.
The other correction mode of the Reed Solomon type will now be examined.

The Reed Solomon structure (RS)

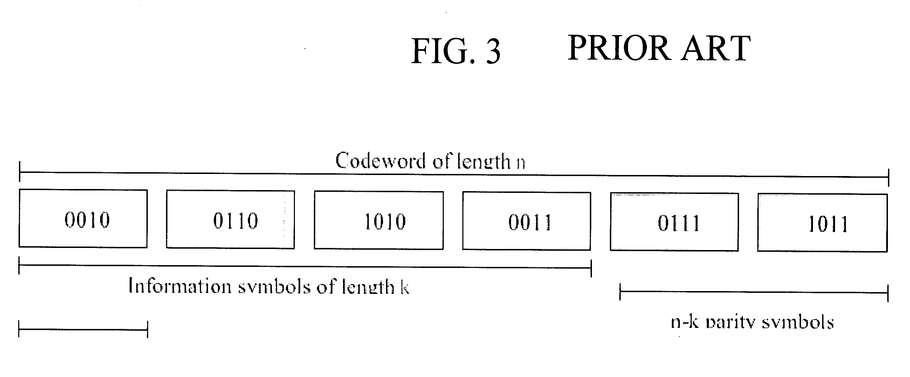

Reed - Solomon codes do not operate on bits but on symbols. As shown in figure 3, the code word is composed of N symbols. In the example each symbol is composed of 4 bits. The information field is composed of K symbols while the remaining N-K symbols are used as parity symbols.
The coding block C and the syndrome calculation block 1 are similar to the ones used for BCH codes with the only difference that they operate on symbols. The error detector block 3 must determine, besides the error position, also the correction symbol to be applied to the wrong symbol.
Since the code RS operates on symbols, a clearly lower latency is obtained paying a higher hardware complexity due to the fact that operators are no more binary.
BLOCK C: the block latency is equal to the number of symbols in the message to be coded (462);
BLOCK 1: the block latency is equal to the number of symbols in the coded message (470);
 BLOCK 3: the block latency is equal to the number of symbols in the coded message (470);
Also in this case the same conditions about the bit grouping and decomposition occur. This time however the Reed-Solomon code does not operate in a sequential way on bits but on s-bit symbols.
Also in this case structures for grouping bits are required, but to ensure a continuous data flow the clock time must be 8/s. It must be observed that in the case s = 8 these architectures are not required.
In this way the latency problem is solved, but, by comparing the number of parity bits required by BCH and Reed-Solomon, it can be seen that Reed-Solomon is much more expensive.
In the case being considered by way of example, i.e. 4224 (4096+128) data bits for correcting four errors, Reed - Solomon codes require twenty parity bits more than BCH binary codes.
Although advantageous under several aspects, known systems do not allow the latency due to the sequential bit processing to be reduced by keeping a number of parity bits yet, and thus an area, close to the theoretical minimum.
In substance, the advantages of the code RS low latency are accompanied by a high demand of parity bits and a higher system structural complexity.
The technical problem underlying the present invention is that of devising an error correction method and system having respective functional and structural features such as to allow the coding and decoding burdens to be reduced, reducing both the latency and the system structural complexity, thus overcoming the drawbacks of the solutions provided by the prior art.

Summary of the invention

The solution idea underlying the invention is to obtain for each coding and decoding block a good compromise between the speed and the occupied circuit area by applying a BCH code of the parallel type requiring a low number of parity bits and having a low latency.

By using this circuit solution it is possible to use for each coding and decoding block the most convenient parallelism and thus latency degree, taken into account that, in the Flash memory, the coding block is only involved in writing operations (only once since it is a non volatile memory), the first decoding block is involved in all reading operations (and it is the block requiring the greatest parallelism), while correction blocks are only called on in case of error and thus not very often.

In this way it is possible to optimise the system speed reducing in the meantime the circuit area occupied by the memory device.

On the basis of this solution idea, the technical problem is solved by a method as previously indicated and defined in claim 1.

The problem is also solved by a system as previously indicated and defined in claim 4.

The features and advantages of the methods and systems according to the invention will be apparent from the following description of an embodiment thereof given by way of indicative and non limiting example with reference to the attached drawings.

In these drawings:

Brief description of the drawings

Figure 1 is a schematic block view of a BCH coding and decoding system;

Figure 2 is a schematic block view of the system of figure 1 emphasising some blocks being responsible for grouping and decomposing bits;

Figure 3 shows how the Reed-Solomon code, coding symbols rather than coding bits, operates;

Figure 4 shows how the parity calculation block operates for a traditional BCH code;

Figure 5 is a schematic view of a base block for calculating the parity in the case of the first parallelization type;

Figure 6 shows the block being responsible for calculating the parity as taught by the first parallelization method for a particular case;

Figure 8 is a schematic view of the block being responsible for searching the roots of the error detector polynomial through the Chien method by using a traditional BCH code;

Figure 9 specifies what the test required by the Chien algorithm means, particularly what summing the content of all the registers and the constant 1 involves;

Figure 10 shows what multiplying the content of a register by a power of $\alpha$ as required by the Chien algorithm involves;

Figure 11 is a schematic view of the architecture of an algorithm for searching the roots of an error detector polynomial in the case of a parallel BCH coding according to the first parallelization method;

Figure 12 specifies Figure 11 in greater detail, i.e. it shows for which powers of $\alpha$ it is necessary to multiply the register content in the case of the first by-four parallelization;

Figure 13 is a schematic view of a base block for calculating the parity according to the traditional BCH method;

Figure 14 is a schematic view of a circuit being responsible for calculating in parallel the parity according to the second method and by parallelizing twice;

Figure 15 is a schematic view of a circuit for calculating the parity by parallelizing q times according to the second method;

Figure 16 is a schematic view of a circuit block being responsible for calculating the "syndrome" of a BCH binary code;

Figure 17 is a schematic view of a circuit block being responsible for calculating the "syndrome" for a parallelized code according to the second method of the present invention;

Figure 18 is a schematic view of the architecture of an algorithm for searching the roots of an error detector polynomial in the case of a known serial BCH code;

Figure 19 is a schematic view of the architecture of an algorithm for searching the roots of an error detector polynomial in the case of a parallel BCH coding according to the second method of the present invention;

Figure 20 is a schematic block view of the system of a further embodiment of the error correction system according to the invention, emphasising some blocks being responsible for grouping and decomposing bits in parallel;

## Detailed description

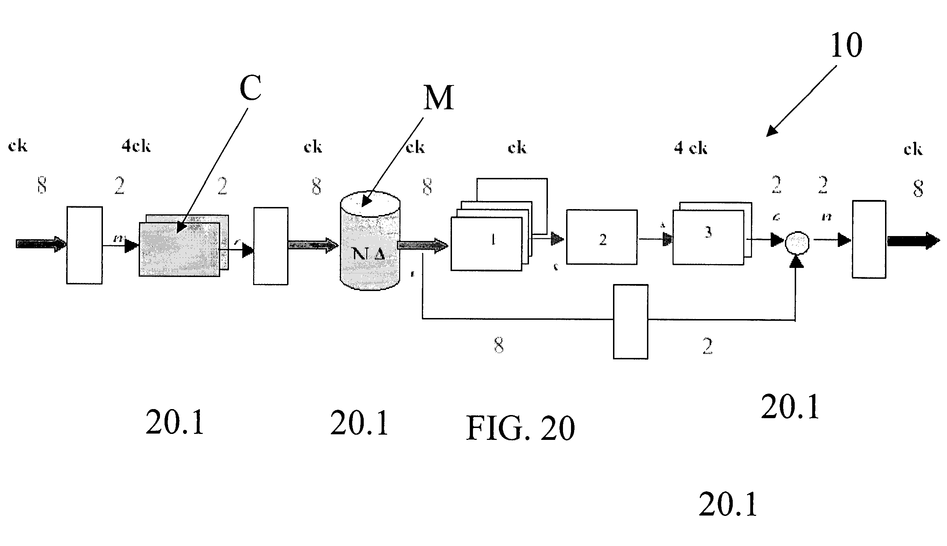

With reference to the figures of the attached drawings, and particularly to the example of figure 20, an error correction system realised according to the present invention for information data to be stored in electronic non volatile memory devices, particularly multilevel reading and writing memories, is globally and schematically indicated with 10.
The system 10 comprises a block indicated with C representing the coding step; a block M indicating the electronic memory device and a group of blocks 1, 2 and 3 which are active during the decoding step. In particular, the block 1 is responsible for calculating the so-called code syndrome; the block 2 is a calculation block, while the block 3 is responsible for detecting the error by means of the Chien wrong position search algorithm.
The blocks indicated with 20.1 represent the parallelism conversion blocks on the data flow.
The invention is particularly suitable for the use in a Flash EEPROM memory M having a NAND structure; nevertheless nothing prevents the invention from being also applied to memories with NOR structure, provided that they are equipped with an error correction system.
Advantageously, the method and system according to the invention is based on an information data processing by means of a BCH code set parallel in the coding step and/or in the decoding step in order to obtain a low latency. The parallelism being used for blocks C, 1 and 3 is selected to optimise the system performance in terms of latency and device area.
Two different methods to make a BCH binary code parallel are provided.
In substance, the parallel scanning can be performed in any phase of the data processing flow according to the application requirements.
The mathematical basics whereon the two parallelization methods of a BCH code according to the invention are based will be described hereafter.

## First parallelization method:

Coding (block C) and syndrome calculation (block 1)

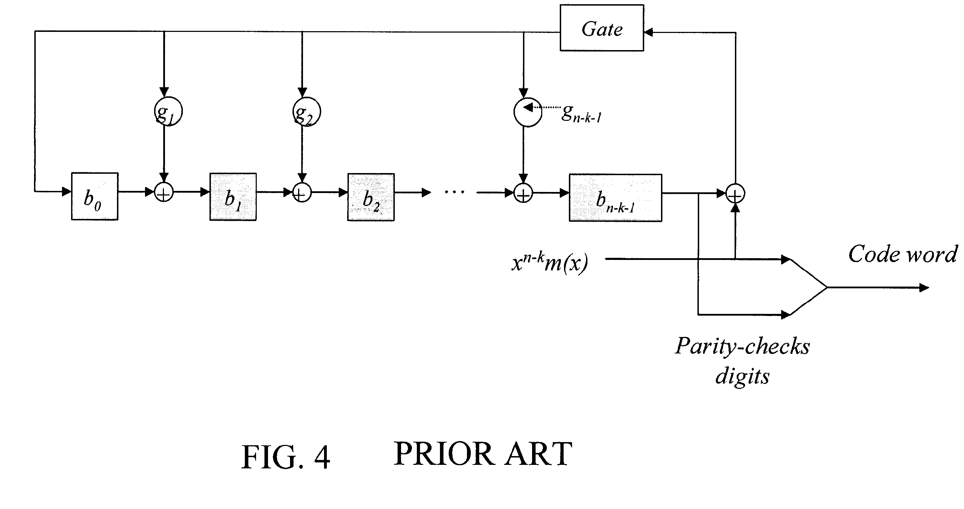

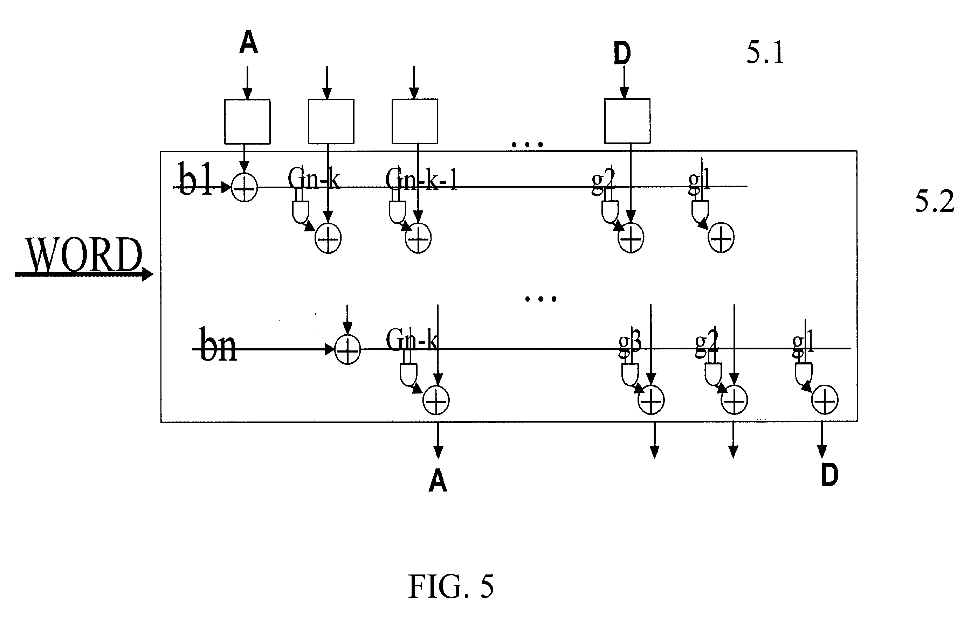

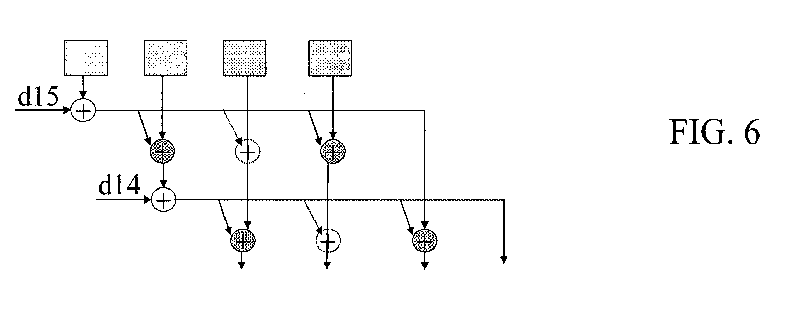

The structures for the syndrome coding and calculation are very similar since both involve a polynomial division.
With reference to figure 4, the traditional BCH coding structure (prior art) is composed of $b_i$ representing memory elements, by adders being simple binary xors and $g_i$ can be either 1 or 0, i.e. the dividend coefficients, this means to say that either there is the connection (and consequently the adder) or such a connection does not exist.
The message to be coded enters the circuit performing the division and it simultaneously goes out being so shifted that in the end the coded message is composed of the initial data message and of the parity being calculated in the circuit.
The method intends to parallelize the division calculating the parity of the data to be written in the memory.
The structure being proposed, in the case of n input data, is represented in figure 5.
Registers 5.1 are initially reset. The words to be coded are applied to the logic network 5.2 in succession. After a word has been applied to the logic network 5.2, the outputs of the logic network 5.2 are stored in the registers 5.1. Once the message last word is applied, registers 5.1 will comprise the parity bits to be added to the data message.
It must be observed that the number of adders depends on the number one of the code generator polynomial.
The example of a BCH [15,11] code with generator polynomial g(x) = 11011 is to be seen, in the illustrative case of two input data (Figure 6). Hatched adders are not present since over there g(x) is zero.

The syndrome calculation structure is absolutely similar to the coding structure. Each syndrome is calculated by dividing the datum being read from the memory for convenient polynomial factors of the code generator polynomial (prior art) and in the end the register content will be valued at $\alpha$, $\alpha^3$, $\alpha^5$ ed $\alpha^7$ by means of a matrix up to obtaining the syndromes. The method being shown for parallelizing the parity calculation can thus be similarly used for the syndrome calculation.

Search for the error detection polynomial Fast BCH.

This block is unchanged with respect to the traditional BCH, but it must be observed that, although it is more complex than the decoding algorithm, it is the one requiring less time.

Search for error detection numbers

**[0065]** The syndromes being known, the error detection polynomial is searched, whose roots are the inverse of the wrong positions. This polynomial being known, it is thus necessary to find the roots. This search is performed by means of the Chien algorithm (prior art).
The algorithm carries out a test for all the field elements in order to check if they are the roots of the error detection polynomial.
If $\alpha^i$ is a root of the error detection polynomial, then the position n-i is wrong, where n is the code length.

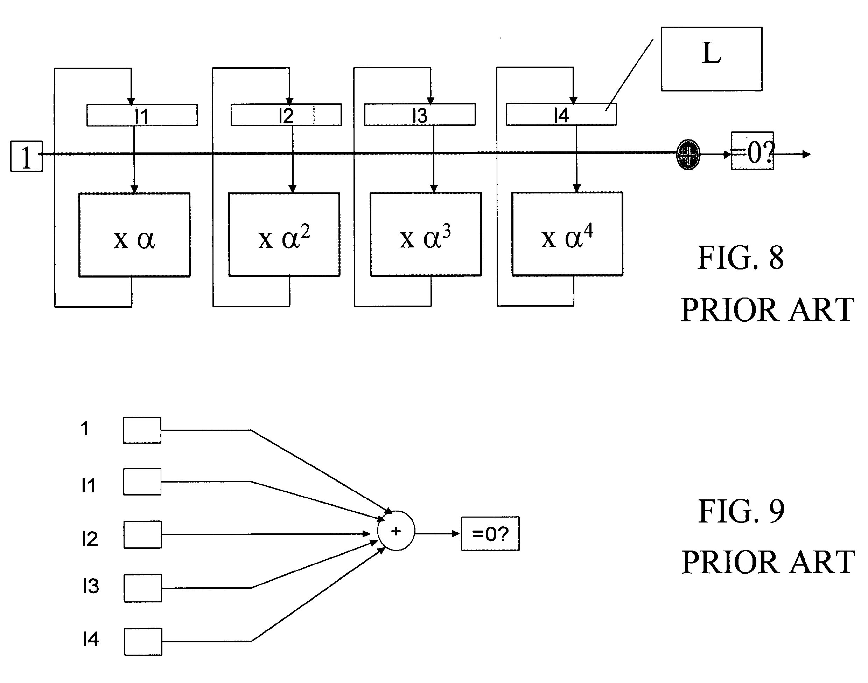

Figure 8 is a schematic view of this structure, where registers L comprise the error detection polynomial coefficients, they are thus m-bit registers when operation occurs in a field GF($2^m$) (in the case being taken as an example m=13).
At this point, for each field element, it must be seen if this is a root of the error detection polynomial, i.e. to check if the following equation is valid for some j.

$$1 + l_1\alpha^j + ... + l_t\alpha^{jt} = 0 \qquad j = 0,1,...,n-1$$

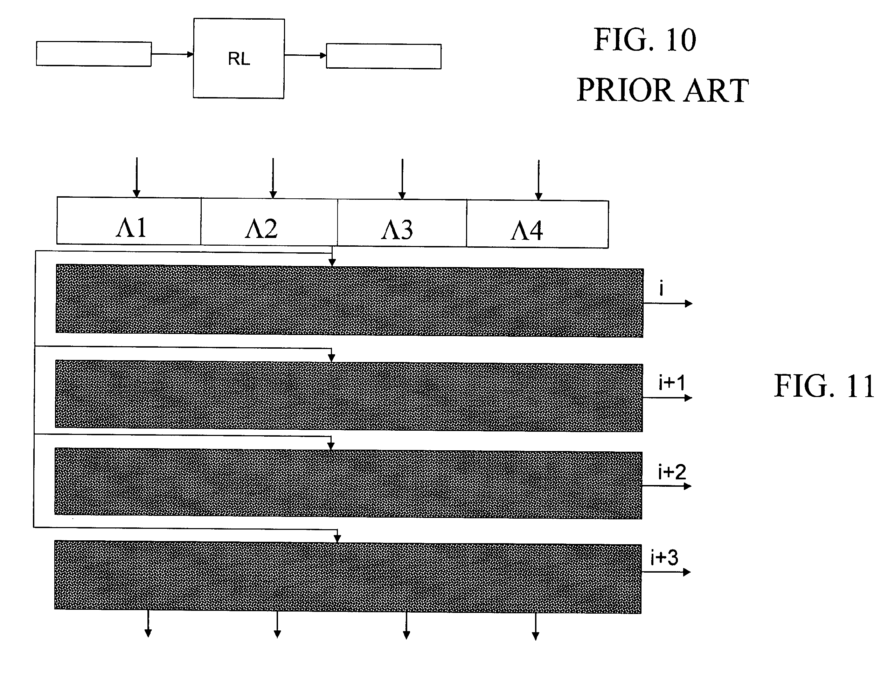

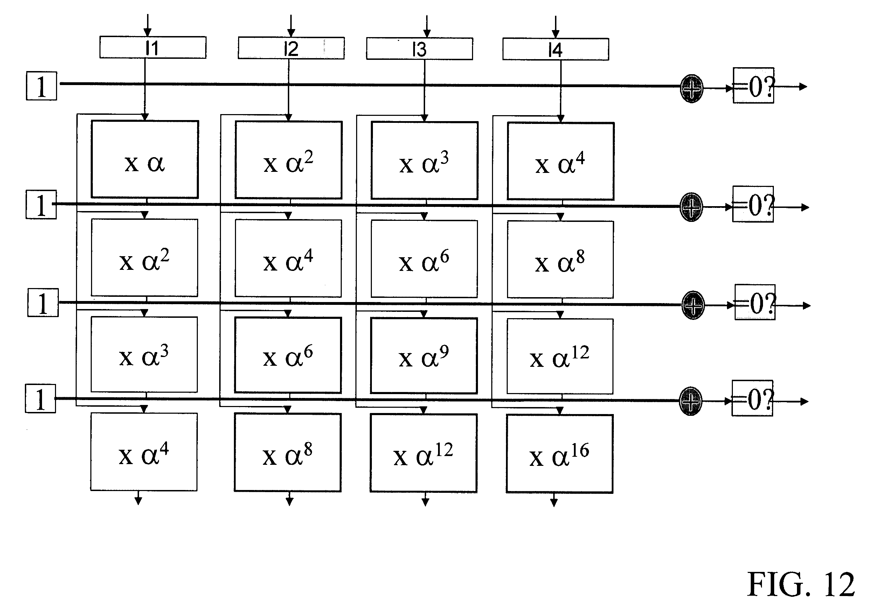

Consequently, a total sum is performed of all the register contents and the field element '1' as shown in figure 9. Multiplication blocks (x $\alpha$, x $\alpha^2$,...) serve to generate all the field elements and they are performed by means of a logic network being described by means of a matrix whose input is an m-bit vector and whose output is an m-bit vector, as schematically shown in figure 10.
With reference to figure 11 parallelizing the algorithm means simultaneously carrying out several tests, and consequently checking several wrong positions. Each block represents a test and the content at the end of the last block is carried into the registers containing the error detection polynomial. In the figure case, four tests are simultaneously carried out so that with a single clock stroke it is possible to know if $\alpha^i$, $\alpha^{i+1}$, $\alpha^{i+2}$ o $\alpha^{i+3}$ are the roots of the error detection polynomial.
Figure 12 shows in greater detail the block composition, a four-step parallelism is used, where after every four steps the values return into the registers containing the four lambda coefficients. Also in this case there will be 52 registers (4 registers having 13 bits each).

Second parallelization method:

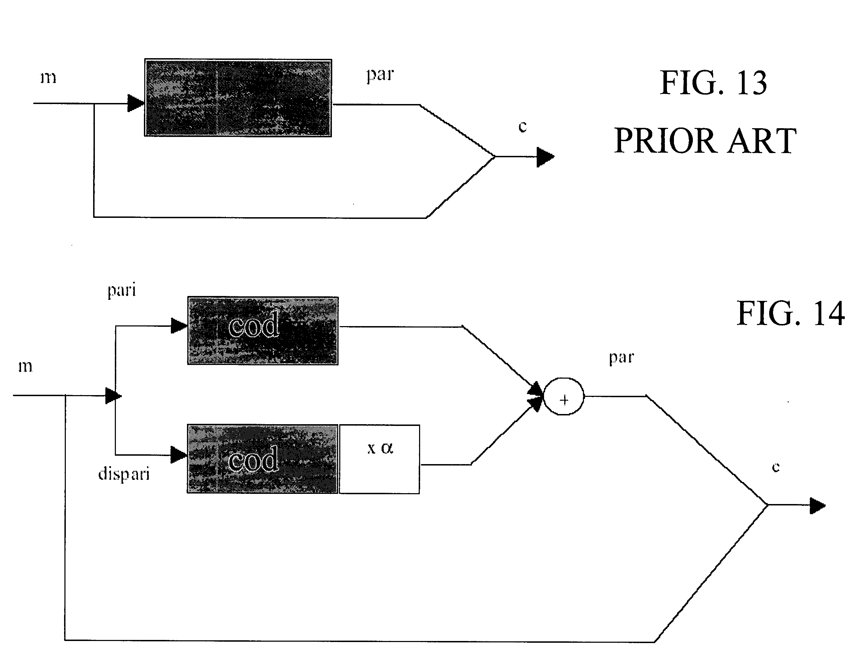

The structure of the system 10 according to the invention, incorporating coding and decoding blocks, is similar to the structure of an error correction system having a traditional BCH binary code; nevertheless, the internal structure of each block changes.
According to the invention it is provided to break the initial information message n times and to operate autonomously on each block. The possibility to break the initial information block into two blocks is considered by way of example; there will be thus bits in the even position and bits in the odd position so that two bits enter at a time in the circuit and the speed doubles.
Generally, parity bits are calculated according to the following relation (1), shown in figure 13:

$$par = x^{n-k} m(x) \bmod g(x) \tag{1}$$

where m(x) is the data message and g(x) is the code generator polynomial.

Operating in parallel, parity bits par1 and par2 are calculated according to these relations:

$$par = par1 + par2 \quad \text{where:}$$

$$par1 = [(x^{n-k}m(x))_{\text{even}} \bmod g(x)] \quad \text{estimated in } \alpha^2$$

$$par2 = \alpha \times [(x^{n-k}m(x))_{\text{odd } j} \bmod g(x)] \quad \text{estimated in } \alpha^2$$

$$(2)$$

An example of known circuit allowing the coding (1) to be realised is shown in figure 13.

Figure 13 thus schematically shows a base block being responsible for calculating the parity by sequentially operating on bits.

On the contrary, for calculating the parity in the double parallelization case the structure of figure 14 can be used.

The blocks indicated with "cod" perform both the division as in the traditional algorithm and the estimate in $\alpha^2$. This estimate can be carried out by means of a logic network being described by a matrix.

As regards odd bits, it is then necessary to multiply the results by $\alpha$, following the modes being already described.

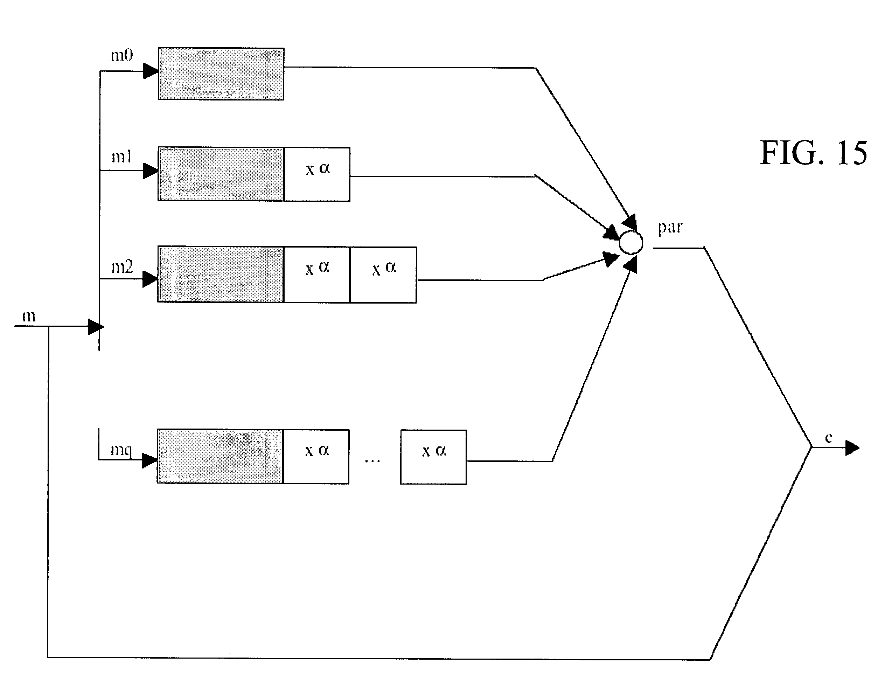

If the circuit is to be further parallelized in a plurality of q blocks, reference can be made to the example of figure 15 wherein the outputs of the multiple blocks converge in a single adder node producing the parity.

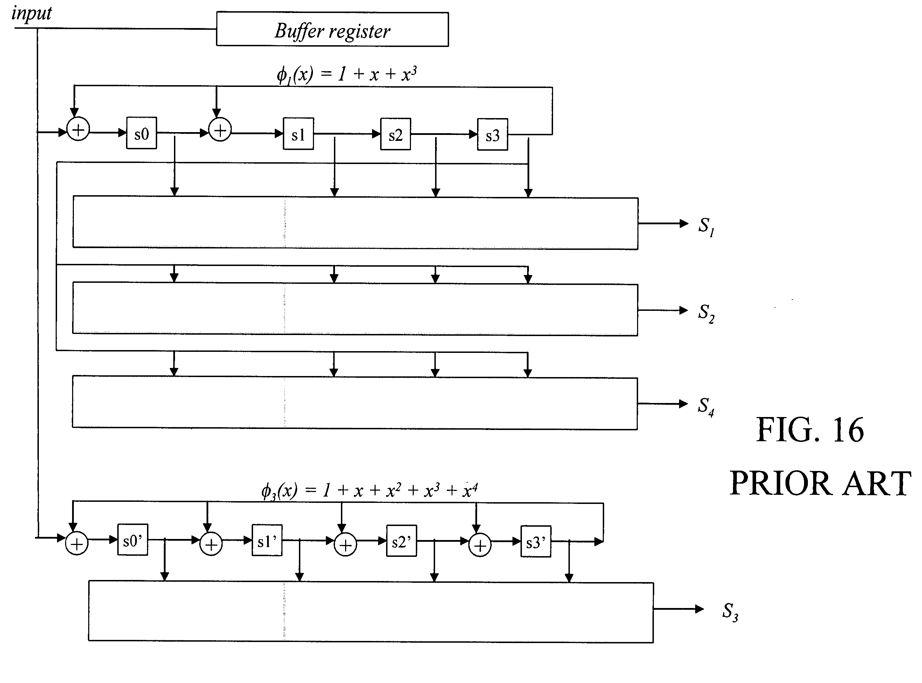

In the case of the traditional serial BCH binary coding it is possible to calculate the so-called code syndromes by means of the following calculation formula (3), corresponding to the circuit block diagram of figure 16, in the particular case of a BCH code [15,7]:

$$S_j = \sum_{i=0}^{n-1} \alpha^{ij} r_i \qquad j = 0,1,\ldots 2t - 1$$

On the contrary, according to the present invention, the syndrome calculation is set out on the basis of the following formulas (4):

$$S_j = S1_j + S2_j \quad \text{where:}$$

$$S1_j = \sum_{l=0}^{\frac{n-1}{2}} \alpha^{2lj} r_{2l}$$

$$S2_j = \alpha^j \times \sum_{l=0}^{\frac{n-1}{2}} \alpha^{2lj} r_{2l+1}$$

A possible implementation of the syndrome calculation according to the prior art is shown in figure 16 wherein two errors in a fifteen-long message are supposed to be corrected.

Consequently, a division is performed similarly to the coding in order to obtain the remainder in the registers marked with s0, s1,....This remainder (seen as a polynomial) must then be valued in $\alpha$, $\alpha^2$, $\alpha^3$, $\alpha^4$ as above described, for example by using a logic network being described by matrixes.

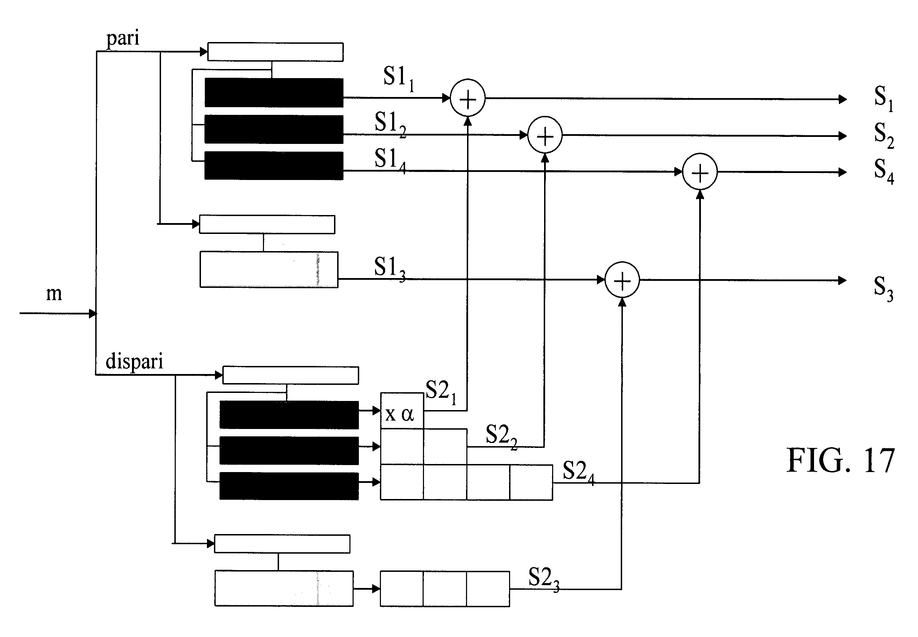

The structure of figure 17 represents a simple parallelization obtained for calculating the syndromes for the code taken as an example according to the parallel structure proposed by the present invention and described by the previous formulas.

The blocks shown in figure 17 are substantially unchanged with respect to a traditional serial BCH binary coding; nevertheless, it is worth observing that the corresponding decoding algorithm is more complex, but it requires less latency.

In particular, two bits are analysed simultaneously, the evens and the odds and a structure similar to the traditional syndrome calculation occurs for both.

In fact, both for the evens and for the odds, there is a block calculating the remainder of the division of the input message with a polynomial, a factor of the code generator polynomial.

These remainders must be now valued in precise $\alpha$ powers, but differently from the traditional syndrome calculation, this time they are valued in $\alpha^2$, $\alpha^4$, $\alpha^6$ and in $\alpha^8$.

In the case of odd bits, a multiplication for different $\alpha$ powers must be also performed.

The results of the even block and of the odd block will be then added in order to obtain the final syndromes.

Now, according to the prior art, a search algorithm of the roots of the error detection polynomial is located in block 3 and it provides the replacement of all the field elements in the polynomial

In substance, in the case of a serial BCH code, a test is performed for all the elements of the following field, according to the following formula:

$$1 + l_1 \alpha^j + ... + l_t \alpha^{jt} = 0 \qquad j = 0,1,...,n-1 \tag{5}$$

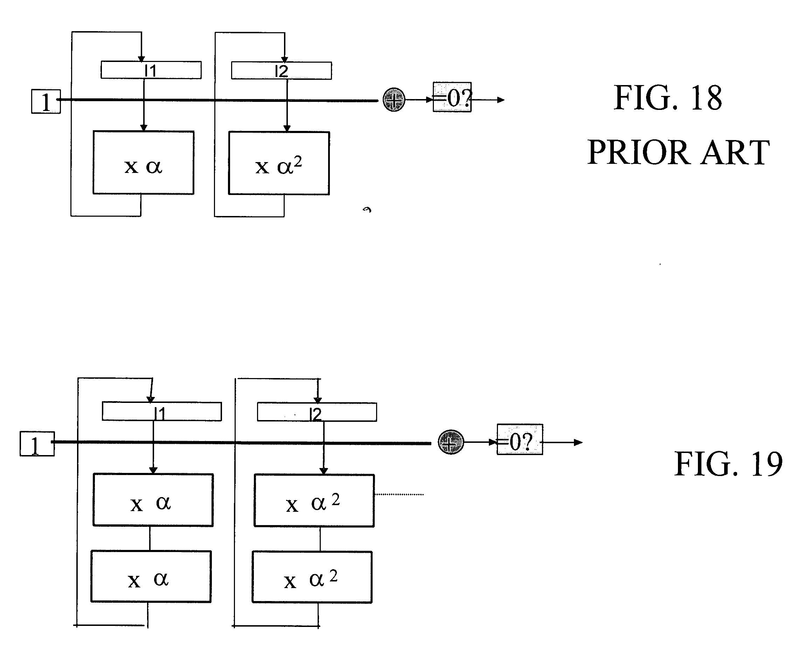

In the traditional serial BCH code, always assuming to correct two errors, a circuit structure like the one of figure 18 would be obtained, corresponding to the previous formula (5).

According to the invention, and assuming to parallelize only once, two circuits are obtained, checking each half of the field elements and thus two different tests TEST1 e TEST2:

$$TEST1) \quad 1 + l_1 \alpha^{2j} + ... + l_t \alpha^{2jt} = 0 \qquad j = 0,1,...,\frac{n-1}{2}$$

$$TEST2) \quad 1 + l_1 \alpha^{2j+1} + ... + l_t \alpha^{(2j+1)t} = 0 \qquad j = 0,1,...,\frac{n-1}{2}$$

Consequently, parallelizing this portion means having several circuits replacing different field elements in the error detection polynomial. In particular, by parallelizing twice the diagram of figure 19 is obtained, which is reiterated twice, considering that for the second time registers are initialised by multiplying by $\alpha$, expressely corresponding to the formulation of the two tests TEST1 e TEST2.

The first circuit performs the first test, i.e. it checks if the field elements being even $\alpha$ powers are the roots of the error detection polynomial, while the second checks if the odd $\alpha$ powers are the roots of the error detection polynomial.

The previous description has shown how to realise parallel structures for coding blocks C, syndrome calculation blocks 1 and error correction blocks 3.

It will be proved hereafter how, no correlation existing between the parallelism of one block and the parallelism of another block, it is very advantageous to structure the coding and decoding system 10 architecture in a structure having a hybrid parallelism, and thus a hybrid latency.

Specific reference will be made to the example of figure 20 showing a hybrid-parallelism coding and decoding system 11.

The coding and decoding example of figure 20 always concerns an application for multilevel NAND structure memory devices.

Assuming an error probability of $10^{-5}$ on a single bit for the NAND memory M, since the protection code operates on a package of 4096 bits, the probability that the package is wrong is 1 out of 50.

In order to understand if the message is correct, the syndrome calculation in block 1 must always be performed. For this reason for block 1 it is suitable to use a high parallelism in order to reduce the overall average latency.

The Chien circuit (block 3) performing the correction must be called on only in case of error (1 out of 50), it is thus suitable, for an area reduction, to use a low-parallelism structure for this single block 3 circuit.

For the coding block C it is possible to choose the most suitable parallelism for the application in order to optimise the coding speed or the overall system area.

The solution of the present invention allows the coding and decoding time to be reduced by varying the parallelism at will.

Another advantage is given by the fact that the independency of the parallelism of each block being involved in coding and decoding operations allows the performances and the system 10 or 11 area to be optimised according to the applications.

**Claims**

1. A method for correcting errors in read and write non volatile memory electronic devices, particularly Flash memories, of the type providing, for the information data to be stored, at least the use of a BCH binary error correction code, **characterised in that** it provides a processing with a first predetermined parallelism for the coding step, a processing with a second predetermined parallelism for the syndrome calculation and a processing with a third predetermined parallelism for calculating the error position, each parallelism being defined by a respective integer number being independent from the others.

2. A method according to claim 1, **characterised in that** it provides a parallel polynomial division for the coding and syndrome calculation.

3. A method according to claim 1, **characterised in that** the integer numbers concerning the first, second and third parallelism are different from each other.

4. A system for correcting errors in read and write non volatile electronic memory devices, particularly Flash memories, of the typen providing the use of a coding block (C) having a BCH binary correction code and a cascade of decoding blocks (1, 2, 3) wherein a first block (1) is responsible for the code syndrome calculation, a second calculation block (2) and a third block (3) being responsible for the error detection, **characterised in that** it comprises a parallel division of at least one of said blocks in the coding and/or decoding step.

5. A system according to claim 4, **characterised in that** said parallel division provides the parallel multiplication of the structure of a given block and the association of bit composition and decomposition architectures.

6. A system according to claim 4, **characterised in that** said parallel division concerns coding (C), syndrome calculation (1) and error detection (3) blocks.

7. A system according to claim 4, **characterised in that** parity bits in the error correction are calculated according to the following relation:

$$par = x^{n-k} m(x) \bmod g(x)$$

where m(x) is the data message and g(x) is the code generator polynomial and **in that** in the parallel scanning parity bits (par1, par2) are calculated according to these relations:

$$par = par1 + par2 \quad \text{where:}$$

$$par1 = [(x^{n-k} m(x))_{\text{even}} \bmod g(x)] \text{ estimated in } \alpha^2$$

$$par2 = \alpha \times [(x^{n-k} m(x))_{\text{odd}} \bmod g(x)] \text{ estimated in } \alpha^2$$

FIG. 1     PRIOR ART

FIG. 2

# FIG. 3    PRIOR ART

Codeword of length n

| 0010 | 0110 | 1010 | 0011 | 0111 | 1011 |

Information symbols of length k

n-k parity symbols

EP 1 612 950 A1

FIG. 4    PRIOR ART

EP 1 612 950 A1

FIG. 5

EP 1 612 950 A1

FIG. 6

EP 1 612 950 A1

L

I1   I2   I3   I4

1

x α    x α²    x α³    x α⁴

=0?

FIG. 8
PRIOR ART

1
I1
I2
I3
I4

+   =0?

FIG. 9
PRIOR ART

EP 1 612 950 A1

FIG. 10

PRIOR ART

RL

FIG. 11

Λ1 Λ2 Λ3 Λ4

i

i+1

i+2

i+3

FIG. 12

FIG. 13
PRIOR ART

FIG. 14

EP 1 612 950 A1

FIG. 15

input

| Buffer register |

$$\phi_1(x) = 1 + x + x^3$$

$S_1$

$S_2$

$S_4$

# FIG. 16

# PRIOR ART

$$\phi_3(x) = 1 + x + x^2 + x^3 + x^4$$

$S_3$

FIG. 17

EP 1 612 950 A1

## FIG. 18
## PRIOR ART

I1 I2

1 ⊕ =0?

x α    x α²

## FIG. 19

I1 I2

1 ⊕ =0?

x α    x α²

x α    x α²

FIG. 20

European Patent
Office

**EUROPEAN SEARCH REPORT**

Application Number

EP 04 42 5486

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 912 905 A (SAKAI ET AL) 15 June 1999 (1999-06-15) * column 4, line 40 - line 55 * * column 6, line 35 - line 60 * * column 7, line 16 - column 9, line 40 * * column 9, line 66 - column 10, line 32 * * column 11, line 36 - line 49 * * figures 1-3 * | 1-7 | H03M13/15 G06F11/10 |
| X | MATSUSHIMA T K ET AL: "PARALLEL ENCODER AND DECODER ARCHITECTURE FOR CYCLIC CODES" IEICE TRANSACTIONS ON FUNDAMENTALS OF ELECTRONICS, COMMUNICATIONS AND COMPUTER SCIENCES, INSTITUTE OF ELECTRONICS INFORMATION AND COMM. ENG. TOKYO, JP, vol. 79, no. 9, September 1996 (1996-09), pages 1313-1323, XP000679621 ISSN: 0916-8508 * the whole document * | 1-7 | |
| A | EP 1 353 446 A (BROADCOM CORPORATION) 15 October 2003 (2003-10-15) * the whole document * | 1-7 | **TECHNICAL FIELDS SEARCHED (Int.Cl.7)** G06F H03M |
| A | EP 1 175 015 A (NEC CORPORATION) 23 January 2002 (2002-01-23) * the whole document * | 1-7 | |

The present search report has been drawn up for all claims

| Place of search | Date of completion of the search | Examiner |
|---|---|---|
| Munich | 27 April 2005 | Bauer, R |

EPO FORM 1503 03.82 (P04C01)

## ANNEX TO THE EUROPEAN SEARCH REPORT
## ON EUROPEAN PATENT APPLICATION NO.

EP 04 42 5486

This annex lists the patent family members relating to the patent documents cited in the above-mentioned European search report.
The members are as contained in the European Patent Office EDP file on
The European Patent Office is in no way liable for these particulars which are merely given for the purpose of information.

27-04-2005

| Patent document cited in search report | | Publication date | Patent family member(s) | | Publication date |
|---|---|---|---|---|---|
| US 5912905 | A | 15-06-1999 | CN | 1126397 A ,C | 10-07-1996 |
| | | | DE | 19509728 A1 | 28-09-1995 |
| | | | FR | 2717968 A1 | 29-09-1995 |
| | | | JP | 3288883 B2 | 04-06-2002 |
| | | | JP | 7312560 A | 28-11-1995 |
| | | | US | 5699368 A | 16-12-1997 |
| EP 1353446 | A | 15-10-2003 | US | 2003154436 A1 | 14-08-2003 |
| | | | EP | 1353446 A2 | 15-10-2003 |
| EP 1175015 | A | 23-01-2002 | JP | 3485075 B2 | 13-01-2004 |
| | | | JP | 2002033669 A | 31-01-2002 |
| | | | AU | 760187 B2 | 08-05-2003 |
| | | | AU | 5446101 A | 24-01-2002 |
| | | | EP | 1175015 A2 | 23-01-2002 |
| | | | US | 2002029367 A1 | 07-03-2002 |

EPO FORM P0459

For more details about this annex : see Official Journal of the European Patent Office, No. 12/82